# EUROPÄISCHE PATENTSCHRIFT

(11) **EP 2 541 262 B1**
(45) Veröffentlichungstag und Bekanntmachung des Hinweises auf die Patenterteilung: **22.08.2018**
(21) Anmeldenummer: 12186410.2
(22) Anmeldetag: 28.07.2006
(51) Int. Cl.: H02M 7/5387, G01R 21/133, H02M 1/00

(54) **VERLUSTLEISTUNGSMESSUNG IN EINEM WECHSELRICHTER**
MEASUREMENT OF DISSIPATED POWER IN AN INVERTER
MESURE DE LA PUISSANCE DISSIPÉE DANS UN ONDULEUR

(30) Priorität: 29.07.2005 DE 102005036317
(43) Veröffentlichungstag der Anmeldung: 02.01.2013
(62) Teilanmeldung aus: 06776484.5
(73) Patentinhaber: Wobben Properties GmbH, 26607 Aurich (DE)
(72) Erfinder: Wobben, Aloys, 26607 Aurich (DE)
(74) Vertreter: Eisenführ Speiser

(56) Entgegenhaltungen:
- WO-A2-99/19974
- DE-A1- 10 127 776
- DE-A1- 10 151 575
- DE-B- 1 005 181
- JP-A- 2003 189 668
- US-A- 5 107 190
- US-A1- 2002 079 706
- US-A1- 2004 196 678
- MUNK-NIELSEN S ET AL: "Simulation with ideal switch models combined with measured loss data provides a good estimate of power loss", INDUSTRY APPLICATIONS CONFERENCE, 2000. CONFERENCE RECORD OF THE 2000 IEEE 8-12 OCTOBER 2000, PISCATAWAY, NJ, USA,IEEE, Bd. 5, 8. Oktober 2000 (2000-10-08), Seiten 2915-2922, XP010521701, ISBN: 0-7803-6401-5
- HIRAKI E ET AL: "Practical power loss analysis simulator of soft switching and hard switching pwm inverters and performance evaluations", COMMUNICATIONS, CIRCUITS AND SYSTEMS AND WEST SINO EXPOSITIONS, IEEE 2002 INTERNATIONAL CONFERENCE ON JUNE 29 - JULY 1, 2002, PISCATAWAY, NJ, USA,IEEE, Bd. 2, 29. Juni 2002 (2002-06-29), Seiten 1690-1695, XP010631844, ISBN: 0-7803-7547-5

## Beschreibung

Die vorliegende Erfindung betrifft einen Wechselrichter und eine Windenergieanlage.

Als Stand der Technik sind bekannt US 2004/0196678 A1, US 2004/0125523 A1, US 5,841,262 A, US 2004/0085117 A1, DE 101 41 125 A1, DE 103 19 354 A1, DE 35 26 836 A1, DE 39 05 701 A1, EP 0 397 514 A2, WO 02/080343 A1, WO 2004/012326 A1, WO 03/065567 A1, WO 02/07315 A1.

In Wechselrichtern werden heute häufig sogenannte IGBT's als Schalter verwendet, um aus einem Gleichstrom einen Wechselstrom zu erzeugen, wobei der Aufbau solcher Wechselrichter an sich bekannt ist. Die Schalter haben ganz unvermeidlich Schaltverluste, die an Hand bekannter Formeln errechnet werden können. Hier ist anzumerken, dass einem IGBT zugeordnete Freilaufdioden von dem Begriff "Schalter" mit erfasst sein sollen.

Bei der Auslegung eines Wechselrichters können also die Betriebsparameter definiert und als Grundlage für die Berechnung verwendet werden. Damit Berechnung und Realität übereinstimmen, müssen diese Parameter während des Betriebs des Wechselrichters eingehalten werden.

In der Praxis erfolgt die Steuerung des Wechselrichters häufig unter Überwachung der Schaltertemperatur. Diese Steuerung basiert auf der Tatsache, dass sich die Schalter durch die Verluste erwärmen und damit die Erwärmung ein Maß für diese Verluste ist.

Stellt nun eine Temperaturüberwachung die Überschreitung eines vorgegebenen Schwellenwertes fest, dann wird der Wechselrichter abgeschaltet, um eine Beschädigung zu vermeiden. Hinzu kommt, dass solche Schalter, die auf der Basis von Halbleitern aufgebaut sind, empfindlich auf thermische Überlastung reagieren. Je höher die thermische Belastung eines solchen Schalters ist, um so höher ist sein thermisches Lebensalter und um so eher muss er demnach ersetzt werden.
Wird ein solcher Wechselrichter in einer Windenergieanlage verwendet, dann muss in Folge der Abschaltung des Wechselrichters auch die Windenergieanlage abgeschaltet werden.
Um die Verlustleistung messen zu können, ist es z. B. erforderlich, bei durchgeschaltetem IGBT die Kollektor-Emitter-Spannung zu messen. Diese hat einen Wert im unteren einstelligen Bereich und muss möglichst genau erfasst werden, um bei sehr hohen Strömen (mehrere hundert Ampere) ein ausreichend genaues Ergebnis zu erhalten. Im gesperrten Zustand liegt an diesen Anschlüssen aber die volle Zwischenkreisspannung an (mehrere hundert Volt). Das Dokument JP2003-189668 A zeigt einen Wechselrichter mit einer Vielzahl von elektronischen Schaltern. Unter Verwendung des Ausgangssignals eines Strom-Messwandlers werden Stromwerte und Spannungswerte bestimmt, aus denen dann eine Verlustleistung ermittelt wird.

Aufgabe der vorliegenden Erfindung ist es daher, einen verbesserten Wechselrichter vorzusehen, bei dem die tatsächlich in einem Schalter auftretende Verlustleistung bestimmt werden kann.
Diese Aufgabe wird durch einen Wechselrichter nach Anspruch 1 gelöst.
Diese Aufgabe wird erfindungsgemäß gelöst durch ein Verfahren zum Bestimmen der Verlustleistung eines elektronischen Schalters, dass dadurch gekennzeichnet ist, dass der Momentanwert einer physikalischen Größe erfasst wird, ein mit dem Momentanwert korrelierter Wert aus einem ersten Speicher abgefragt wird, beide Werte in vorbestimmter Weise miteinander verarbeitet werden und das Ergebnis der Verarbeitung ausgegeben wird.
Dabei liegt der Erfindung die Erkenntnis zu Grunde, dass aus den bekannten Daten des Schalters, die in Datenblättern veröffentlicht werden, Werte entnommen werden können, die einem durch Messung ermittelten Messwert zugeordnet sind. In dem vorliegenden Beispiel kann bei einem bekannten Strom durch den Schalter aus dem Datenblatt z. B. die Kollektor-Emitter-Spannung (Vce) ermittelt werden. Eine Multiplikation des fließenden Stromes mit dieser Kollektor-Emitter-Spannung ergibt die Verlustleistung für den momentan durch den Schalter fließenden Strom. Hinzu kommen noch die Schaltverluste beim Ein- und Ausschalten des Schalters.

Um die Verlustleistung nicht nur eines Schalters sondern eines vollständigen Wechselrichters bestimmen zu können, werden in einer Weiterbildung der Erfindung die physikalischen Größen mehrerer Schalter erfasst und eine entsprechende Mehrzahl korrelierter Werte wird aus dem Speicher ausgelesen.

Besonders bevorzugt werden die Messwerte und die Zwischenergebnisse der Verarbeitung gespeichert. Dadurch kann man auch später auf diese Werte, z. B. für statistische Auswertungen o. ä., zurückgreifen.

Zur Ausführung des Verfahrens ist eine Vorrichtung zum Bestimmen der Verlustleistung des elektronischen Schalters vorgesehen, gekennzeichnet durch einen Dateneingang zur Erfassung des Momentanwertes wenigstens einer physikalischen Größe des elektronischen Schalters, einen ersten Speicher, in welchem mit der physikalischen Größe korrelierte Daten abgelegt sind, eine Verarbeitungseinheit zum Verarbeiten der physikalischen Größen und eines aus dem Speicher abgerufenen Wertes in vorbestimmter Weise miteinander, und eine Einrichtung zum Ausgeben des Resultats der Vereinbarung.

Diese erfindungsgemäße Lösung hat den Vorteil, dass die tatsächliche Verlustleistung eines Schalters erfasst werden kann. Dies ist nicht nur vom fließenden Strom und den Kennwerten des Schalters abhängig. Vielmehr spielen auch Umgebungseinflüsse wie z. B. die Umgebungstemperatur eine Rolle. Durch die erfindungsgemäße Vorrichtung ist daher eine Erfassung der tatsächlichen Verlustleistung zu einem gewünschten Zeitpunkt möglich. Damit kann also die tatsächliche Belastung des Schalters sehr viel genauer bestimmt werden als mit den im Stand der Technik bekannten rechnerischen Prognosen.

In einer bevorzugten Weiterbildung umfasst die Vorrichtung eine Mehrzahl von Eingängen zum Erfassen der Momentanwerte der physikalischen Größen mehrerer Schalter. Auf diese Weise kann mit der Vorrichtung die Verlustleistung z. B. eines gesamten Wechselrichters erfasst werden.

Um den Verlauf der Verlustleistung über einen längeren Zeitraum auswerten zu können, ist besonders bevorzugt ein zweiter Speicher zum Speichern von Messwerten und Zwischenergebnissen vorgesehen. Dieser kann aber mit dem ersten Speicher baulich vereinigt sein.

Da elektronische Schalter vorgegebene Grenzwerte für den Betrieb haben, jenseits denen sie nicht betrieben werden sollten, ist die Vorrichtung vorzugsweise gekennzeichnet durch eine Einrichtung zum Vergleichen des Ergebnisses der Verarbeitung mit einem vorgegebenen Grenzwert und Ausgeben eines Signals bei Erreichen bzw. Überschreiten des Grenzwertes. Dabei kann die Vorrichtung vorteilhaft als eigenständiges Gerät ausgebildet sein, das bei Bedarf auf einfache Weise zum jeweiligen Verwendungsort transportiert werden kann. Alternativ kann die Vorrichtung auch in die Steuerung eines Wechselrichters oder einer Windenergieanlage integriert sein.

Neben dem Ausgeben des Signals, das zur Benachrichtigung z. B. eines Bedieners oder eines Betreibers eines solchen Gerätes verwendet werden kann, kann das Signal besonders bevorzugt auch an die Steuerung des Wechselrichters oder der Windenergieanlage ausgegeben werden, um die Steuerung in vorgegebener Weise zu beeinflussen.

Diese Beeinflussung kann bei einem nach dem Toleranzbandverfahren arbeitenden Wechselrichter vorteilhaft darin bestehen, dass die Toleranzbandbreite erhöht wird, wenn die Vorrichtung ein Signal ausgibt, welches das Überschreiten des Grenzwertes anzeigt. Ist also die Verlustleistung eines Schalters zu hoch, kann die Toleranzbandbreite vergrößert werden. Damit singt die Schalthäufigkeit und damit auch die Einschalt- bzw. Ausschalt-Verluste und folglich insgesamt die Verlustleistung des Schalters (einschließlich der Freilaufdioden).

Besonders bevorzugt ist eine Windenergieanlage mit wenigstem einem derartigen Wechselrichter ausgestattet. Dabei ist ein Verfahren zur Steuerung einer Windenergieanlage dadurch gekennzeichnet, dass durch das Signal, welches ein Überschreiten eines vorgegebenen Grenzwertes angibt, die von der Windenergieanlage erzeugte Leistung verringert wird. Damit wird auch die durch den Wechselrichter zu verarbeitende Leistung geringer und entsprechend verringert sich auch die Verlustleistung in den Schaltern.

Dabei kann eine erfindungsgemäße Vorrichtung an die Steuerung der Windenergieanlage angeschlossen sein, um so die Steuerung der Windenergieanlage direkt und nicht auf dem Weg über einen Wechselrichter beeinflussen zu können.

Nachfolgend wird die Erfindung an Hand der Figuren näher beschrieben. Dabei zeigen:
- Fig. 1: eine vereinfachte Darstellung einer erfindungsgemäßen Vorrichtung;
- Fig. 2: ein Beispiel einer Anwendung der Vorrichtung bei einer Windenergieanlage;
- Fig. 3: ein zweites Anwendungsbeispiel der Erfindung bei einer Windenergieanlage;
- Fig. 4: eine vereinfachte Darstellung des erfindungsgemäßen Verfahrens;
- Fig. 5: eine vereinfachte Darstellung einer Schalterbrücke für eine Phase eines Wechselrichters; und
- Fig. 6: eine Darstellung des erfindungsgemäßen Verfahrens.

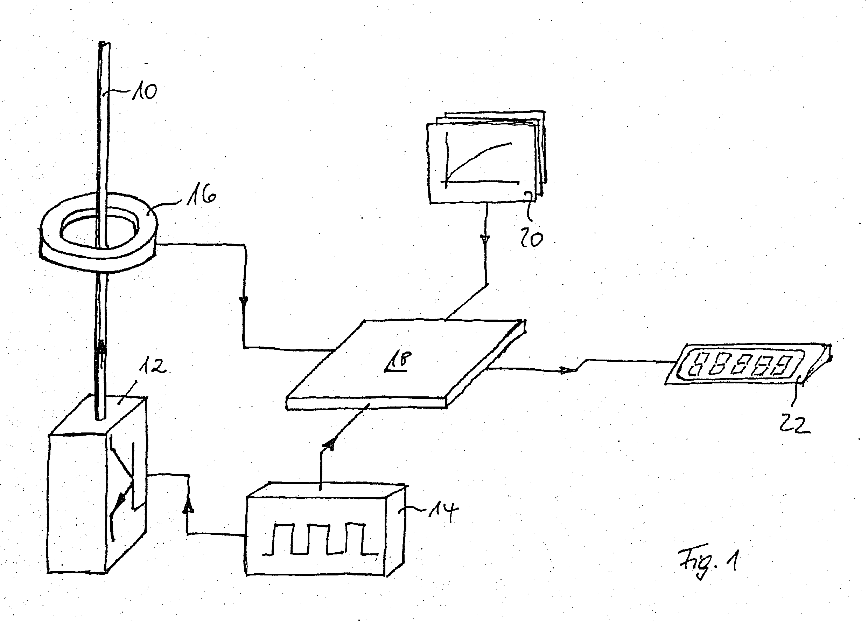

In der in Fig. 1 gezeigten vereinfachten Darstellung einer erfindungsgemäßen Vorrichtung bezeichnet das Bezugszeichen 10 einen Leiter, der an einen Schalter 12 (wie z. B. einen IGBT) angeschlossen ist und der den erzeugten Wechselstrom abgibt. Der Schalter wird von einer Steuerung 14 angesteuert. Der in dem Leiter 10 gemessene Strom wird mit einem Messwandler 16 erfasst und einer Verarbeitungseinheit 18 zugeführt. Diese Verarbeitungseinheit 18 erhält auch die Ansteuerungsinformationen von der Steuerung 14 als Triggerereignis, um die jeweiligen Schaltmomente präzise bestimmen zu können. Entsprechend dem durch den Messwandler 16 ermittelten Strom in dem Leiter 10 wird von einer Tabelle 20 ein entsprechender Spannungswert für die Kollektor-Emitter-Spannung abgerufen und aus diesen Werten kann dann die tatsächliche Verlustleistung des Schalters 12 ermittelt werden. Das Ergebnis kann z. B. auf einer Anzeige 22 angezeigt werden. Natürlich können diese Werte auch in einen (in der Figur nicht dargestellten) Speicher eingetragen werden. Dieser Speicher ermöglicht dann das Sammeln von Daten, die zu Auswertungszwecken z. B. über eine (ebenfalls nicht dargestellte) Schnittstelle zu einem Computer übertragen werden können.

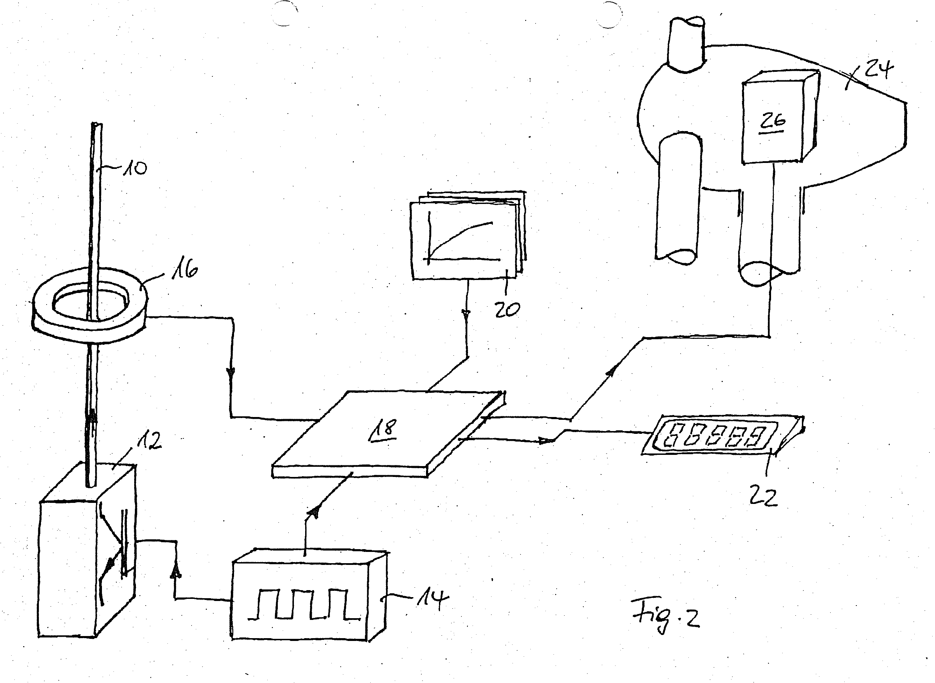

Die Darstellung in Fig. 2 entspricht weitgehend derjenigen in Fig. 1. Hinzu gekommen ist die Darstellung einer Gondel einer Windenergieanlage 24 mit einer darin vorgesehenen Steuerung 26. Somit kann abhängig von Ergebnis der Berechnung in der Verarbeitungseinheit 18 nicht nur das Berechnungsergebnis auf der Anzeige 22 angezeigt werden, sondern gleichzeitig oder alternativ kann die Steuerung 26 der Windenergieanlage 24 beeinflusst werden, um z. B. auf diese Weise auf das Überschreiten eines Grenzwertes reagieren zu können. Entsprechend kann die Windenergieanlage veranlasst werden, die erzeugte Leistung zu verringern. Bei pitchgeregelten Windenergieanlagen ist dies durch Verändern des Anstellwinkels der Rotorblätter in bekannter Weise möglich.

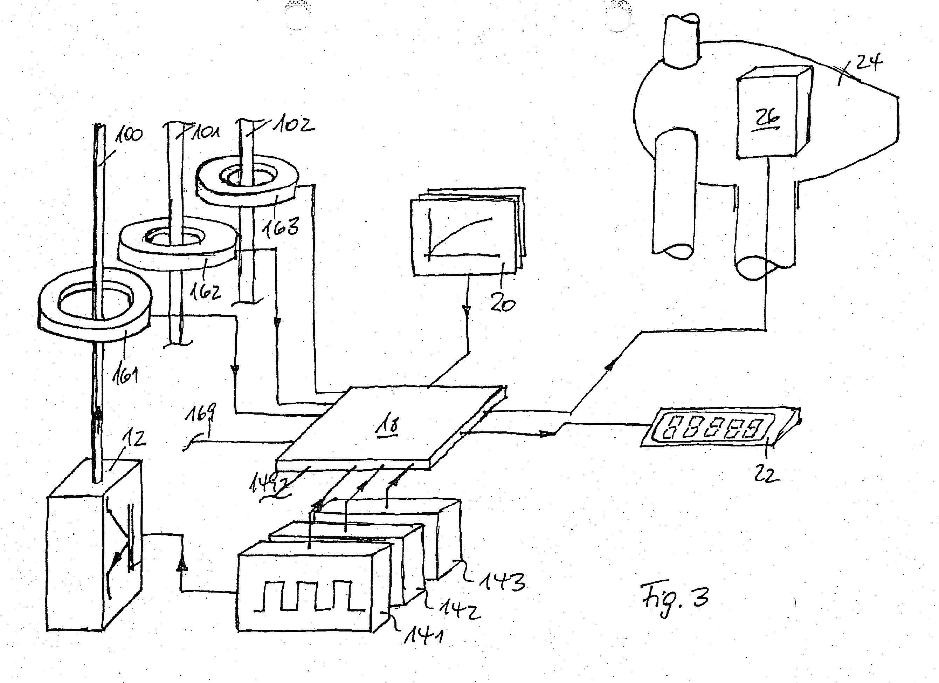

Fig. 3 ist im Vergleich zu Fig. 2 um Messwandler und Ansteuerungen ergänzt. In dieser Figur sind mehrere Leiter 100, 101, 102 dargestellt, in denen der fließende Strom mit Messwandlern 161, 162, 163 erfasst wird. Zur Verbesserung der Übersichtlichkeit sind die zusätzlichen Schalter nicht dargestellt. Durch eine Leitung 169 ist angedeutet, dass hier natürlich noch mehrere Messwandler als Beispiel für die Erfassung einer physikalischen Größe an die Verarbeitungseinheit 18 angeschlossen werden können.

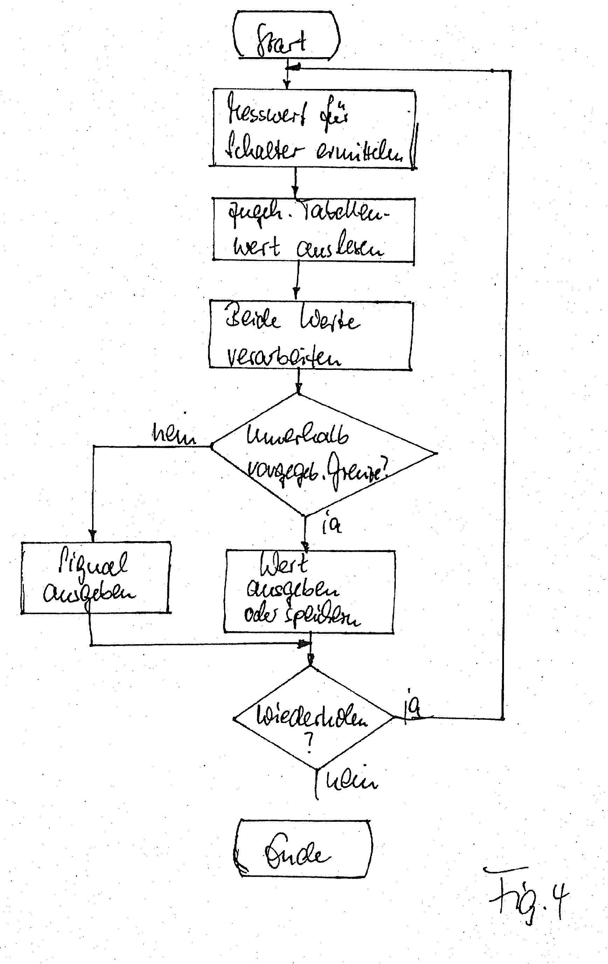

Entsprechend der Anzahl der Leitungen sind auch entsprechende Ansteuerungen 141 142, 143 vorgesehen. Von jeder dieser Steuerungen verläuft eine Leitung zu der Verarbeitungseinheit 18, so dass für jeden in eine der Leitungen 100, 101, 102 einspeisenden Schalter jeweils ein Trigger-Impuls abgegeben werden kann. Wie vorstehend beschrieben, kann zu jedem erfassten Strom-Wert aus der Tabelle 20 ein entsprechender Wert für die Kollektor-Emitter-Spannung des Schalters abgerufen werden und daraus die momentane Verlustleistung bestimmt werden. Die Ergebnisse können dann wieder zu einer Anzeige 22 bzw. der Steuerung 26 einer Windenergieanlage 24 ausgegeben werden. Natürlich ist es auch möglich, entsprechende Signale zu anderen Einrichtungen wie Mobiltelefonen, Fernüberwachungszentralen, usw. abzugeben, um entsprechende Benachrichtigungen auszulösen.
Die Darstellung in Fig. 4 zeigt einen Ablaufplan für das erfindungsgemäße Verfahren. Nach dem Start wird zunächst der Messwert für einen Schalter ermittelt. An Hand dieses Messwertes wird im nächsten Schritt aus der Tabelle der dazugehörige Datenwert ausgelesen und danach werden die beiden Werte verarbeitet, in diesem Fall also miteinander multipliziert, um die momentane Verlustleistung des Schalters zu bestimmen. Danach kann eine Prüfung erfolgen, ob der ermittelte Wert innerhalb einer vorgegebenen Grenze ist. Wenn nein, kann ein Signal ausgegeben werden. Natürlich kann alternativ oder ergänzend auch eine Anzeige vorgenommen werden. Dann kann die Messung wiederholt werden oder auch nicht. Dabei kann die Wiederholung für den gleichen Schalter oder auch für einen anderen Schalter erfolgen.

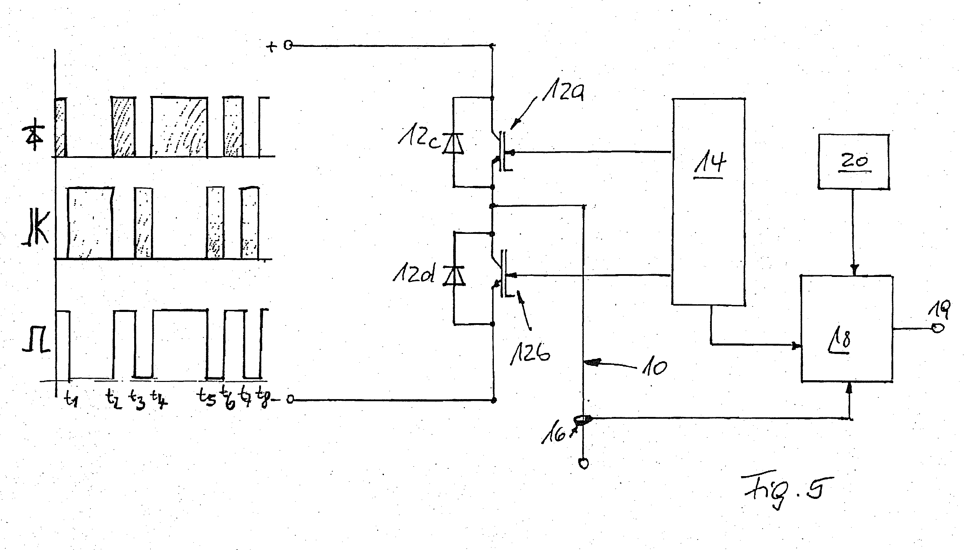

Fig. 5 zeigt vereinfacht die Anordnung von zwei Schaltern 12a und 12b, mit denen der Strom für eine Phase erzeugt werden kann. Zu den Schaltern gehören auch die Freilaufdioden 12c und 12d. In der Mitte zwischen den beiden Schaltern 12a und 12b befindet sich der Abgriff für die Phase und die Leitung 10 entspricht der in den Figuren 1 - 3 dargestellten Leitung 10. Durch einen Messwandler 16 wird der Strom erfasst, der in dieser Leitung 10 fließt, und einer Verarbeitungseinheit 18 zugeleitet.

Eine Steuerungseinheit 14 steuert die Schalter 12a und 12b. Gleichzeitig gibt sie entsprechende Trigger-Signale an die Verarbeitungseinheit 18 aus. Diese Trigger-Signale können in dem Ansteuerungstakt der Schalter 12a und 12b bestehen.

Die Verarbeitungseinheit 18 liest aus der Tabelle 20 die zu den Stromwerten gehörigen Werte für die Kollektor-Emitter-Spannung aus und gibt das Ergebnis an einem Ausgang 19 aus. Dieser Ausgabe kann z. B. eine Anzeige sein, ein Signal an eine Überwachung und/oder ein Signal, welches den Wechselrichter bzw. die Windenergieanlage beeinflusst.

Für das Verständnis der folgenden Erläuterung ist es hilfreich, das Zusammenwirken von Schalter 12a und Freilaufdiode 12c bzw. Schalter 12b und Freilaufdiode 12d zu betrachten. Dies ist im linken Teil der Fig. 5 beispielhaft für den Schalter 12a sowie die Freilaufdiode 12c dargestellt. Gezeigt sind drei übereinander dargestellte Schaltmuster. Das untere Schaltmuster, das am linken Rand mit einem Rechteck gekennzeichnet ist, sei der von der Steuerung 14 ausgegebene Schaltakt für den IGBT 12a. Dabei führt eine abfallende Flanke zum Einschalten des IGBT's und eine ansteigende Flanke zum Ausschalten des IGBT's und zum Einschalten der Freilaufdiode. Während der Takt von der Steuerung zu Beginn auf einem hohen Pegel ist, ist entsprechend der IGBT ausgeschaltet und die Freilaufdiode ist leitend. Entsprechend entstehen dort Flussverluste. Zum Zeitpunkt t1 hat das Steuerungssignal eine abfallende Flanke. Der IGBT wird eingeschaltet und die Diode sperrt. Entsprechend treten die Flussverluste jetzt am Schalter auf, wie dies auch in der mittleren der Darstellungen zu erkennen ist. Der Vollständigkeit halber sei erwähnt, dass durch Leckströme in der Diode im Sperrzustand noch entsprechende Leckverluste auftreten.

Zum Zeitpunkt t2 zeigt das Taktsignal eine ansteigende Flanke. Entsprechend wird der IGBT 12a abgeschaltet und die Freilaufdiode 12c schaltet durch. Zum Zeitpunkt t3 fällt das Taktsignal ab, der IGBT 12a schaltet ein und die Diode sperrt. Dies ist noch bis zum Zeitpunkt t8 weiter dargestellt.

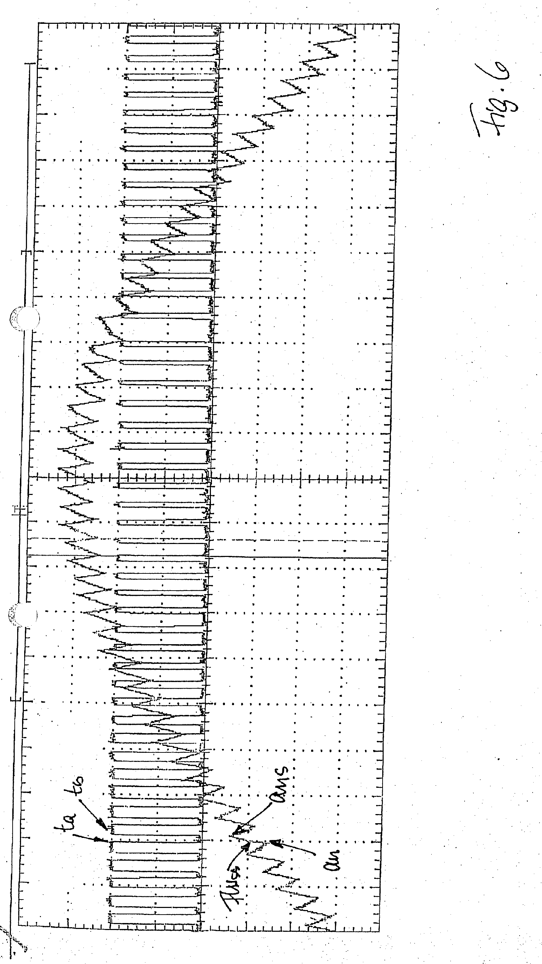

Fig. 6 zeigt den Zusammenhang zwischen den Taktimpulsen, die hier wieder als Rechteckimpulse dargestellt sind, und dem Strom in dem Leiter 10. Zum Zeitpunkt ta hat Taktsignal eine abfallende Flanke. Entsprechend schaltet der Schalter durch und der Strom beginnt innerhalb des Toleranzbandes anzusteigen, bis der Schalter zum Zeitpunkt tb abschaltet. Dieses Abschalten des Schalters 12a führt zum Einschalten des Schalters 12b und der Strom sinkt wieder etwas ab, bis ein unterer Wert erreicht wird. Dann schaltet mit der abfallenden Flanke der Schalter 12a wieder ein. Natürlich ist der Schalter 12b dann abgeschaltet und der Strom steigt wieder an. Diese Schaltvorgänge setzen sich so fort, dass insgesamt ein sinusförmiger Stromverlauf entsteht.

Da die Schaltzeitpunkte vom Erreichen der entsprechende Toleranzwerte abhängen, ist ein festes Schema nicht vorhanden. Vielmehr ergeben sich diese Schaltzeitpunkte eben aus dem Erreichen der jeweiligen Grenzwerte.

Während der Schalter eingeschaltet ist, wird im Abstand von 25 us (dieser Wert ist beispielhaft, er kann auch länger oder kürzer sein) der Strom in dem Leiter gemessen und der entsprechende Wert für die Kollektor-Emitter-Spannung wird aus der Tabelle abgerufen. Somit kann der Verlust für den momentanen Stromfluss präzise bestimmt werden.

Insgesamt sind drei Arten von Verlusten beim IGBT zu unterscheiden. Im Einschaltmoment treten Einschaltverluste auf. Diese werden erfasst. Ebenso treten im Ausschaltmoment Ausschaltverluste auf, die auch erfasst werden. Während der Transistor durchgeschaltet ist, treten Flussverluste auf. Auch diese werden erfasst und alle diese Werte können kumuliert werden, um so zu den Verlusten für den IGBT zu kommen.

Alternierend zum Stromfluss durch den IGBT tritt ein Stromfluss durch die Diode auf. Hier kommt es ebenfalls zu Flussverlusten wie auch zu Leckverlusten, wenn die Diode gesperrt ist. Auch diese Werte werden erfasst, kumuliert und mit den für den IGBT gewonnen Werten insgesamt zu den Schaltverlusten zusammengefasst.

Diese Schaltverluste können z. B. für eine Periode der Netzfrequenz oder auch für einen anderen, vorgebbaren Zeitraum wie z. B. eine Sekunde ermittelt werden, um dann die Schaltverluste für eine Periode oder z. B. zur einfacheren Umrechenbarkeit für eine Sekunde bestimmen zu können.

Hierbei können aber nicht nur die Schalter einer Phase berücksichtigt werden (vgl. Fig. 5). Vielmehr können auch die Schalter für drei Phasen sowie für den Schalter z. B. in einem Hochsetzsteller oder in einem Chopper im Zwischenkreis mit erfasst werden.

## Patentansprüche

1. Wechselrichter, mit
einer Vielzahl von elektronischen Schaltern (12),
einem Messwandler (16) zum Messen eines Momentanwertes eines Stroms durch einen der Vielzahl von elektronischen Schaltern (12),
einem Speicher zum Speichern von Daten eines Datenblattes (20) des elektronischen Schalters bezüglich Stromwerten und KolleKtor-Emitter-Spannungswerten.
einer Verarbeitungseinheit (18) zum Multiplizieren des gemessenen Momentanwertes des Stroms mit dem anhand dieses Messwertes aus dem Speicher ausgelesenen Kallektcr-Emitter-Spannungswert, um die momentane Verlustleistung des elektronischen Schalters (12) zu bestimmen, und
einer Ausgabeeinheit zum Ausgeben der ermittelten Verlustleistung,
wobei die Verlustleistung des elektronischen Schalters (12), der eine Freilaufdiode (12c, 12d) aufweist, bes:immt wird.

2. Wechselrichter nach Anspruch 1, ferner mit einem zweiten Speicher zum Speichern von Messwerten und von Zwischenergebnissen.

3. Wechselrichter nach einem der Ansprüche 1 - 2, ferner mit einer Einrichtung zum Vergleichen der ermittelten Verlustleistung mit einem vorgegebenen Grenzwert der Verlustleistung und Ausgeben eines Signals bel Erreichen bzw. Überschreiten des Grenzwertes.

4. Wechselrichter nach einem der Ansprüche 1 - 3, eingerichtet zur integration in die Steuerung eines Wechselrichters einer Windenergieanlage.

5. Wechselrichter nach einem der Ansprüche 1 - 4, eingerichtet zur Ausgabe das Sig-nals an die Steuerung des Wechselrichters oder einer Windenergieanlage, um die Steuerung in vorgegebener Weise zu beeinflussen.

6. Wechselrichter nach einem der Ansprüche 1 - 5, wobei der Wechselrichter nach dem Toleranzbandverfahren arbeitet, wobei die Toleranzbandbreite erhöht wird, wenn ein Signal ausgegeben wird, welches das Überschreiten des Grenzwertes der Verlustleistung anzeigt.

7. Windenergieanlgge mit wenigsten einem Wechselrichter nach einem der Ansprüche 1 - 6,
wobei ein Signal zur Verringerung der von der Windenergieanlage erzeugten Leistung ausgegeben wird, wenn die ermittelte Verlustleistung einen vorgegebenen Grenzwert überschreitet,

## Claims

1. An inverter comprising
a plurality of electronic switches (12),
a measuring transducer (16) for measuring an instantaneous value of current through one of the plurality of electronic switches (12),
a memory for storing data of a data sheet (20) of the electronic switch regarding current values and collector-emitter voltages values, and
a processing unit (18) for multiplying the measured instantaneous current value by the collector-emitter voltage values extracted from the memory (20) based on this measured value to determine the instantaneous dissipated power of the electronic switch (12), and
an output unit for outputting the determined dissipated power,
wherein the dissipated power of the electronic switch (12) which has a free-wheeling diode (12c, 12d) is determined.

2. An inverter according to claim 1 further comprising
a second memory for storing measurement values and intermediate results.

3. An inverter according to one of claims 1 to 2 further comprising
a device for comparing the ascertained dissipated power with a predetermined limit value of the dissipated power and outputting a signal when the limit value is reached or exceeded.

4. An inverter according to one of claims 1 to 3 which is configured to be integrated into the control of an inverter of a wind power installation.

5. An inverter according to one of claims 1 to 4 which is configured to output the signal to the control of the inverter or of the wind power installation to influence the control in a predetermined fashion.

6. An inverter according to one of the claims 1 to 5 wherein the inverter operates in accordance with the tolerance band process wherein the tolerance band width is increased when a signal which indicates the limit value of the dissipated power has been exceeded has been outputted.

7. Wind power installation comprising at least one inverter according to anyone of the claims 1 to 6,
wherein a signal for reducing the power generated by the wind power installation is outputted when the determined dissipated power exceeds a predetermined limit value.

## Revendications

1. Onduleur, avec
une pluralité de commutateurs électroniques (12),
un transducteur (16) pour mesurer une valeur instantanée d'un courant par un de la pluralité de commutateurs électroniques (12),
une mémoire pour mémoriser des données d'une fiche technique (20) du commutateur électronique relativement à des valeurs de courant et des valeurs de tension de collecteur-émetteur.
une unité de traitement (18) pour multiplier la valeur instantanée mesurée du courant avec la valeur de tension de collecteur-émetteur lue dans la mémoire à l'aide de ladite valeur de mesure pour déterminer la dissipation de puissance instantanée du commutateur électronique (12), et
une unité de sortie pour fournir en sortie la dissipation de puissance déterminée,
dans lequel est déterminée la dissipation de puissance du commutateur électronique (12) qui présente une diode de roue libre (12c, 12d).

2. Onduleur selon la revendication 1, avec en outre une seconde mémoire pour la mémorisation de valeurs de mesure et de résultats intermédiaires.

3. Onduleur selon l'une des revendications 1 à 2, avec en outre un dispositif pour comparer la dissipation de puissance déterminée à une valeur limite prédéfinie de la dissipation de puissance et pour émettre un signal lors de l'atteinte ou du dépassement de la valeur limite.

4. Onduleur selon l'une des revendications 1 à 3, agencé pour être intégré dans la commande d'un onduleur d'une éolienne.

5. Onduleur selon l'une des revendications 1 à 4, agencé pour émettre le signal à destination de la commande de l'onduleur ou d'une éolienne pour influer sur la commande de manière prédéfinie.

6. Onduleur selon l'une des revendications 1 à 5, dans lequel l'onduleur fonctionne selon le procédé de la bande de tolérance, dans lequel la largeur de la bande de tolérance est augmentée lorsqu'est émis un signal indiquant le dépassement de la valeur limite de la dissipation de puissance.

7. Eolienne avec au moins un onduleur selon l'une des revendications 1 à 6,
dans laquelle un signal pour limiter la puissance générée par l'éolienne est émis lorsque la dissipation de puissance déterminée dépasse une valeur limite prédéfinie.
